# EUROPEAN PATENT SPECIFICATION

(11) **EP 4 428 274 B1**
(45) Date of publication and mention of the grant of the patent: **23.09.2026**
(21) Application number: 23160851.4
(22) Date of filing: 09.03.2023
(51) Int. Cl.: C30B 29/04, C30B 31/22, C30B 33/04, B82Y 10/00

(54) **SHALLOW COLOUR CENTRES IN DIAMOND FOR APPLICATION IN QUANTUM TECHNOLOGY**
FLACHE FARBZENTREN IN DIAMANT ZUR VERWENDUNG IN DER QUANTENTECHNOLOGIE
CENTRES DE COULEUR PEU PROFONDS DANS DU DIAMANT POUR APPLICATION DANS LA TECHNOLOGIE QUANTIQUE

(43) Date of publication of application: 11.09.2024
(73) Proprietor: Universität Ulm, 89081 Ulm (DE)
(72) Inventor: Lang, Johannes, 89077 Ulm (DE); Findler, Christoph, 89077 Ulm (DE); Osterkamp, Christian, 70806 Kornwestheim (DE); Jelezko, Fedor, 89073 Ulm (DE)
(74) Representative: Pfenning, Meinig & Partner mbB

(56) References cited:
- ANDREAS J. HÄUSSLER ET AL: "Optical depth localization of nitrogen-vacancy centers in diamond with nanometer accuracy", OPTICS EXPRESS, vol. 22, no. 24, 24 November 2014 (2014-11-24), pages 29986, XP055739749, DOI: 10.1364/OE.22.029986
- KAWAI SORA ET AL: "Nitrogen-Terminated Diamond Surface for Nanoscale NMR by Shallow Nitrogen-Vacancy Centers", vol. 123, no. 6, 24 January 2019 (2019-01-24), US, pages 3594 - 3604, XP093020002, ISSN: 1932-7447, Retrieved from the Internet <URL:http://pubs.acs.org/doi/pdf/10.1021/acs.jpcc.8b11274> DOI: 10.1021/acs.jpcc.8b11274
- LANG JOHANNES ET AL: "Long optical coherence times of shallow-implanted, negatively charged silicon vacancy centers in diamond", APPLIED PHYSICS LETTERS, AMERICAN INSTITUTE OF PHYSICS, 2 HUNTINGTON QUADRANGLE, MELVILLE, NY 11747, vol. 116, no. 6, 10 February 2020 (2020-02-10), XP012244532, ISSN: 0003-6951, [retrieved on 20200210], DOI: 10.1063/1.5143014

## Description

This invention relates to a diamond substrate comprising shallow colour centres and to a method for the creation of shallow colour centres in a diamond substrate.

The crystal structure of diamond commonly contains crystallographic defects due to irregularities in the crystal lattice or substitutional atoms in the structure that can have effects on the optical and electronic properties of the diamond. A particular kind of defects is called colour centres, since they result in a visible colouration of the material. These colour centres are formed of anionic vacancies in a crystal lattice that are occupied by one or more unpaired electrons. In diamond, two important kinds of colour centres in particular are caused by the substitution of a carbon atom with a nitrogen atom, which results in a neighbouring lattice vacancy due, or by the substitution of two neighbouring carbon atoms with one silicon atom, which is then positioned between two lattice vacancies. Accordingly, these colour centres are known as nitrogen-vacancy centre (NV centre) and silicon vacancy centre (SiV centre).

The spin state of the colour centre (meaning the spin of the involved electron or electron pair at the vacancy) can be read out via their photoluminescence and manipulated by electromagnetic fields, thus making the colour centres interesting for applications in quantum sensing and computing. In the state of the art, to produce shallow colour centres for these applications, nitrogen or silicon ions are implanted into diamond substrates prepared by chemical vapour deposition via ion beam at low energies of around 1 keV. The substrates are then annealed in order for the vacancies to diffuse through the lattice and to capture the implanted ions, resulting in the desired colour centres. With the addition of an additional electron from the crystal lattive or a nearby donor, in the case of the NV centre, its negative charge state is stabilized.

The positioning of nitrogen vacancy centers by implantation of nitrogen ions into diamond is shown in, for example, A.J. HäuBler et al: "Optical depth localization of nitrogen-vacancy centers in diamond with nanometer accuracy", OPTICS EXPRESS, vol. 22 (2014), no. 24, pages 29986-29995, and S. Kawai et al: "Nitrogen-Terminated Diamond Surface for Nanoscale NMR by Shallow Nitrogen-Vacancy Centers", THE JOURNAL OF PHYSICAL CHEMISTRY C, vol. 123 (2019), no. 6, pages 3594-3604.

However, since the magnetic signal of external spins on the diamond surface which are to be measured by the NV centre is inversely proportional to the third power of the their depth, colour centres close to the surface of a diamond substrate are of particular interest. Furthermore, additional defects of the diamond structure, especially at the surface, such as they occur during ion beam treatment or annealing of a substrate, can negatively impact the spin properties of the colour centres.

Accordingly, the present application sets out to provide a diamond substrate comprising shallow colour centres of improved quality and a method for the creation of such shallow colour centres in a diamond substrate.

This problem is solved by the method of claim 1.

In particular, an exemplary diamond substrate comprising shallow colour centres implanted by utilizing a channelling effect according to the claimed method is characterized in that the colour centres comprise negatively charged colour centres at a depth of less than 1 nm from the surface of the diamond substrate.

The diamond substrate itself is monocrystalline and may be synthesized in a number of ways. For the present application, diamond of type IIa, meaning very low concentrations of both nitrogen and boron impurities, is favourable. Additional nitrogen impurities would otherwise hinder the formation and detectability of implanted nitrogen-vacancies, while boron acts as an electron acceptor and would thus lead to poor charge stability in the colour centres. The surface of the substrate may further be polished.

Since the diamond substrate has a monocrystalline structure, channelling of ions occurs in the crystal. In general, channelling is the dependence of the depth distribution of incident ions on the orientation of the crystal structure, wherein the ions reach larger penetration depths when they are incident in parallel to a major crystal axis. The energy loss of an incident ion is largely dependent on nuclear stopping, wherein the ion interacts directly with a lattice atom and transfers its energy to it, and electronic stopping, wherein the ion interacts with the electrons of the lattice atom and is thus deflected. These and other elastic and inelastic energy loss processes have cross sections that are dependent on the relation between the direction of the crystal structure and the direction of the ion's momentum, resulting in a lower stopping power of the lattice atoms in certain directions. In addition, the ion may be repelled from the nuclei of the lattice atoms and thus "channelled" along a path. In a simplified, classical standpoint, the incident ion has a higher probability of a collision with a lattice atom under an arbitrary incidence angle. If on the other hand, the incidence direction coincided with a major crystal axis, the ion only "sees" a single plane of the crystal structure, with the lattice atoms of the other planes perfectly in line with each other. Thus, the crystal structure forms "channels" in which an ion can penetrate the structure without interacting with the lattice atoms. Utilization of the channelling effect by implantation of ions under an angle coinciding with a major crystal axis thus allows for a well-defined depth distribution. In diamond, directions under which channelling occurs comprise the <100> axes. Please note that due to the cubic nature of the diamond crystal structure, the miller indices indicating planes, such as (100), and those indicating directions [100] or sets of equivalent directions <100> may be used interchangeably since they are orthogonal to each other.

In order to be used for most quantum applications, the colour centres have to have a negative charge. For example, in the case of an NV centre, the vacancy comprises a pair of electrons, while a SiV centre comprises a split vacancy with one electron. While both neutral and positively charged colour centres also exist, in the following the term colour centre will always refer to a negatively charged colour centre and both NV and SiV centres should be read as NV⁻ and SiV⁻ centres.

Since the depth of the implanted colour centres is large and their depth distribution is well-defined, further processing steps, such as annealing and etching, can be performed on the diamond substrate without impairing the function of the colour centres. Via removal of the surface layers of the diamond structures, a depth of the colour centres of less than 3 nm from the surface of the substrate can be achieved, which is not possible with conventional methods.

The depth distribution of the negatively charged colour centres in general may be such that 5 and 75 %, preferably between 10 and 50 %, further preferably between 15 and 35 %, especially preferred between 20 % and 25 % of the negatively charged colour centres are situated at a depth of less than 3 nm from the diamond surface. With a large percentage of the colour centres located close to the surface of the substrate, a strong spin signal for further applications may be guaranteed.

When characterizing the colour centres via Rabi oscillation measurements, the negatively charged colour centres provide a Rabi contrast of more than 15%, preferably between 20 and 60 %, more preferably between 20 and 40 %, especially preferred between 25 and 35 %. This indicates the high quality of the colour centres and that their implantation utilizing the channelling effect keeps the crystal structure of the diamond substrate largely undamaged, so there are no additional defects in the structure that would impact the signal strength.

The shallow colour centres in the diamond substrate may further have a mean coherence time of between 5 µs and 40 µs at a depth of less than 5 nm when measured via a Hahn echo sequence. The long mean coherence time once again indicates that the crystal lattice contains no damages that would negatively impact the coherence time of the colour centres. A long coherence time is also favourable for most applications of the diamond substrate with shallow colour centres.

In particular, the negatively charged colour centres may be nitrogen-vacancy colour centres. Nitrogen-vacancy centres have been extensively studied and find application in magnetic resonance imaging, spectroscopy and a range of quantum sensors for field strengths, pressure and temperature. In addition, their long coherence times also make them attractive for applications in quantum computing and communications.

Alternatively, the negatively charged colour centres may be silicon-vacancy colour centres. Silicon-vacancy centres feature high brightness of narrowband emission as well as a low distribution of photon frequencies, making them a promising candidate for quantum photonic applications.

The diamond substrate may be grown via chemical-vapour deposition (CVD). Chemical vapour deposition is a method well known in the art and is able to produce high-quality type IIa diamonds with low concentrations of impurities. The diamond may be grown on a diamond substrate, resulting in the homoepitaxial growth of a single crystal. Accordingly, a CVD-gown diamond substrate fulfils all the requirements of for the creation of shallow colour centres utilizing a channelling effect.

The method for the creation of shallow colour centres in a diamond substrate, comprising the steps of
identifying a miscut angle between a normal of a surface plane of the diamond substrate and a major crystal axis <100> of a diamond crystal structure,
implantation of ions using an ion beam under an angle, such that the miscut angle is eliminated and the ion beam enters the diamond structure parallel to the major crystal axis of the diamond structure,
annealing of the diamond substrate,
measuring a depth of implanted colour centres,
inductively coupled plasma etching of the diamond substrate such that the implanted colour centres comprise negatively charged colour centres situated at a depth of less than 3 nm from the surface of the diamond substrate.

The diamond substrate may be provided as a CVD-grown diamond substrate. The substrate may additionally be polished. However, even after polishing, a miscut angle between the normal of the surface plane of the diamond substrate and a major crystal axis of the diamond crystal structure (denoted by the group of all major axes <100>) may exist. In other words, the surface of the diamond substrate may not coincide with the plane [100] of the diamond structure. Accordingly, when implanting ions with an ion beam incident orthogonal to the substrate surface, the ion beam may still hit the crystal plane (100) at an angle. Thus, in order to allow channelling, the miscut angle first has to be identified.

With knowledge of the miscut angle, ion implantation of low energy ions can then be performed under an angle, so that the miscut angle is eliminated. This may be achieved with the help of a wedge or the precise calibration of a sample stage. The ion beam can then enter the diamond substrate parallel to a major crystal axis <100> of the diamond structure. The implanted ions thus experience the channelling effect and are able to penetrate deeper into the crystal lattice. Since the ions reach deep into the crystal lattice, the surrounding crystal structure remains largely undamaged.

An annealing step is then required in order for the vacancies to diffuse through the crystal lattice and for the implanted ions to be captured and form colour centres. In addition, the annealing heals the diamond of damages incurred during the ion implantation.

After annealing, the depth distribution of the implanted colour centres is determined. These measurements may be performed by quantum confocal microscopy.

Exact knowledge of the depth distribution of the colour centres then allows the removal of the diamond from the surface of the substrate until the remaining colour centres are provided at a desired depth of less than 3 nm from the surface. This removal is performed with inductively coupled plasma (ICP) etching, in which a plasma is created by an inductive coil, in contrast to reactive ion etching, in which the ions of the plasma are accelerated towards the surface to be etched. Since the inductively coupled plasma thus barely touches the surface of the diamond, ICP etching is comparatively gentle and allows the removal of single atomic layers at slow etching rate, thus allowing for precise removal of unwanted material. In addition, ICP etching leads to a less damaged surface.

As a result, the method produces a diamond substrate in which colour centres are arranged at a depth of less than 3 nm from the surface of the diamond substrate. Since the colour centres are surrounded by a less damaged crystal structure and the ICP etching additionally stabilizes the charge state via surface termination with oxygen, the properties of the colour centres are more uniform throughout the substrate, thus leading to an improved performance when measuring the spin signal, coherence time and Rabi contrast.

The implanted ions can be nitrogen ions, resulting in nitrogen-vacancy centres, which, as stated above, are attractive for many quantum sensing and computing applications.

The implanted ions may also be silicon ions, resulting in silicon-vacancy centres, which, as described above, are attractive for quantum optical applications.

To identify the miscut angle between the normal of the surface plane of the diamond substrate and a major crystal axis <100>, x-ray diffraction (XRD) analysis may be used. X-ray diffraction allows for the angle resolved Bragg-refraction of crystals and is therefore a tool commonly used to characterized the structure of a crystal. By varying the angle of the examined substrate and maximising the Bragg-reflex, the angle between the substrate and the crystal plane [100] can be identified and therefore also the miscut angle.

The implantation of ions may be carried out at with an ion beam energy of between 1 keV and 10 keV, in particular between 4.5 and 5.5 keV, and with a dose of between 1×10⁹ and 5×10¹² ions per cm². While implantation of ions into amorphous crystals are generally performed at lower energies, an ion beam energy of around 5 keV supports the channelling effect, since particle diffraction effects are stronger at lower ion energies. The given dosages allow for the tuning of the density of colour centres between isolated single centres and dense ensembles of colour centres.

Annealing may be performed at a temperature of between 800 °C and 1500 °C and a pressure between 1×10⁻⁸ mbar and 1×10⁻⁶ mbar. In particular, the substrate may be annealed in an UHV chamber.

After annealing, the diamond substrate may be cleaned in a mixture of sulfuric acid, perchloric acid and nitric acid at a temperature of between 100 °C and 130 °C to remove any graphitic residue from the surface.

The inductively coupled plasma etching described above may be performed with an oxygen plasma. Treatment with an oxygen plasma known to stabilize the negative charge state of colour centres by oxygen termination of the dangling bonds of the top layer of carbon atoms of the diamond substrate. This leads to an improved performance of the colour centres in the diamond substrate.

The above-mentioned, as well as other aspects of the invention, will be apparent from the detailed description of the embodiments given with the aid of the following drawings, of which:
Fig. 1a shows the crystallographic structure of a diamond substrate with an NV centre,
Fig. 1b shows the crystallographic structure of a diamond substrate with an SiV centre,
Fig. 2 illustrates the steps of the method of creating shallow colour centres in a diamond substrate,
Fig. 3 shows a schematic cross section of a process chamber used for ICP etching,
Fig. 4a illustrates the identification of a miscut angle via x-ray diffraction,
Fig. 4b shows the crystal lattice of a diamond substrate viewed from three different angles,
Fig. 5 shows a comparison between nitrogen-vacancy occurrence achieved with the method according to the invention and a conventional method,
Fig. 6a illustrates the sequence used for Rabi oscillation measurements,
Fig. 6b shows a comparison between Rabi contrast achieved with the method according to the invention and a conventional method, and.
Fig. 7a illustrates the Hahn echo sequence,
Fig. 7b shows a comparison between mean coherence times before and after ICP etching.

In the following, the diamond substrate comprising shallow colour centres and the method of creating shallow colour centres will be explained in more detail on the basis of the accompanying figures, in which the same reference signs refer to the same elements.

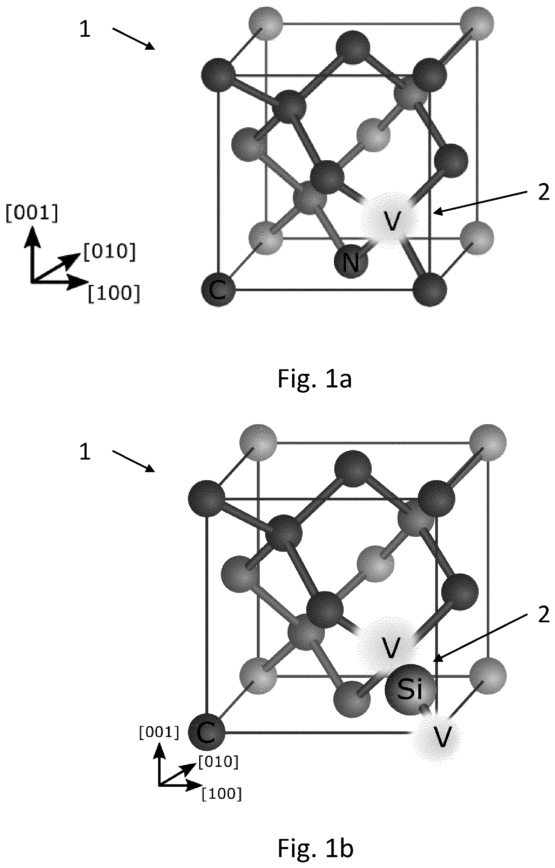

Fig. 1a and 1b show the crystallographic structure of a nitrogen-vacancy centre and a silicon vacancy centre. Fig. 1a displays the unit cell of a diamond structure. The repetition of this unit cell of carbon atoms C then forms the diamond substrate 1. One carbon atom is substituted by a nitrogen atom N, resulting in a neighbouring vacancy V. This forms the nitrogen-vacancy centre 2. The symmetry of the NV centre is along the <111> directions of the diamond structure.

Fig. 1b also displays the unit cell of a diamond structure. Here, two carbon atoms are substituted by a silicon atom Si, resulting in a split vacancy V along the <111> direction. This forms the silicon-vacancy centre 2.

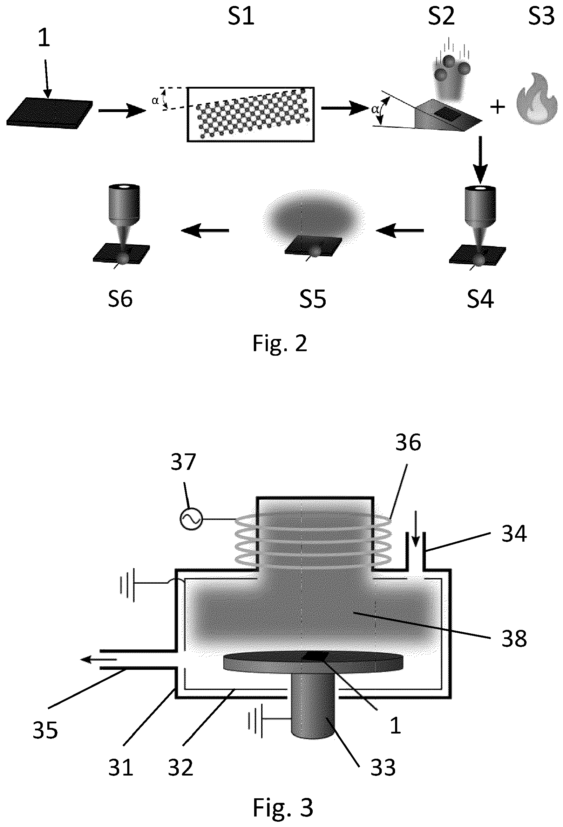

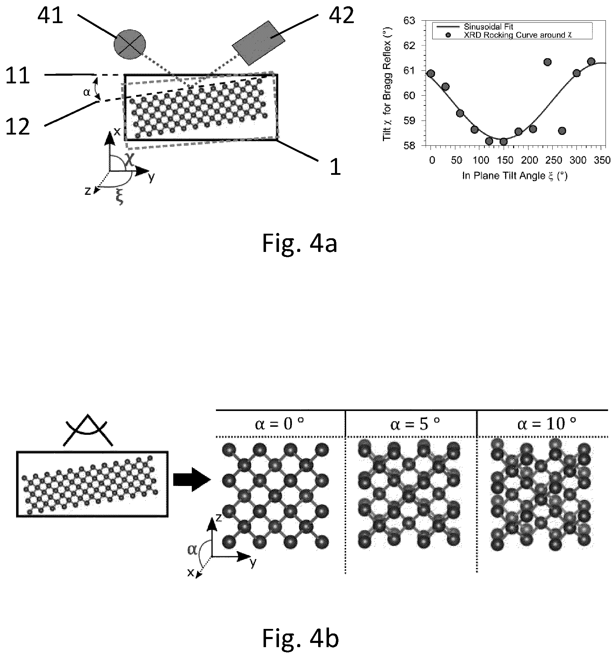

Fig. 2 illustrates the method of creating shallow colour centres in a diamond substrate according to the invention. The starting point is a diamond substrate 1. The substrate may be a type Ila diamond grown via chemical vapour deposition. In a first step S1 the diamond substrate is investigated via x-ray diffraction to identify the angle α between the surface of the substrate 1 and the plane of the (100) of the diamond structure. This also gives the miscut angle between the normal of surface of the diamond substrate and the [100] direction, which in the current example shall be the relevant major crystal axis, though all equivalent axes <100> may also be used. The x-ray diffraction analysis and the angle under which channelling occurs are further described in regard to Fig. 4a and 4b.

In step S2 nitrogen or silicon ions are implanted into the diamond substrate 1. By tilting the substrate by the angle α in step S2, the direction of the major crystal axis [100] and the direction of the ion beam can then be made to coincide. Ion implantation may be performed at an ion energy between 1 keV and 10 keV, preferably at an energy between 4.5 keV and 5.5 keV. The dose may be varied between 1×10⁹ and 5×10¹² ions per cm² to achieve the desired density of colour centres.

In step S3 the diamond substrate 1 with the implanted ions is annealed to form the colour centres by recombining the vacancies with the implanted ions. Annealing may be performed in a UHV high temperature annealing oven at a temperature of between 800 °C and 1500 °C and a pressure between 1×10⁻⁸ mbar and 1×10⁻⁶ mbar. In particular, the oven may be first heated from room temperature to 500 °C so that the substrate can soak at that temperature for an hour and then heated to 1000 °C to fully anneal the substrate for three hours. The temperature may be ramped up by up to 7 °C per minute. Afterwards, the oven is cooled back down to room temperature and the substrate is cleaned in a 1:1: 1 mixture of sulfuric acid, perchloric acid and nitric acid at a temperature of between 100 °C and 130 °C to clean it of any graphitic residues.

In step S4, the depth distribution of the implanted colour centres 2 is analysed. This may be done in a confocal microscope equipped with a magnetic field and a microwave source in order to manipulate the electron spin of the colour centres 2 and to analyse their fluorescence. By applying a XY8-sequence, the depth of the colour centres can be calculated. With the abovementioned parameters, a colour centre depth of about 10 nm is to be expected.

In Step S5, inductively coupled plasma etching is performed to reduce the depth of the colour centres to a desired depth, in particular in such a way as to achieve negatively charged colour centres at a depth of less than 3 nm from the etched surface. ICP etching will be described in closer detail with regard to Fig. 3. Since ICP provides for etching rates of 2 nm to 3 nm per minute, it allows for the removal of material with nanometre precision. Therefore the surface of the substrate can be etched in such a way as to reach the desired depth precisely without endangering the colour centres. In addition, irregularities on the surface in the nanometre range may also be removed in the process. The use of an oxygen plasma also stabilizes the charge state of the colour centres by terminating open bonds on the surface of the diamond substrate and removing damaged crystal lattice in the first few nanometres below the surface.

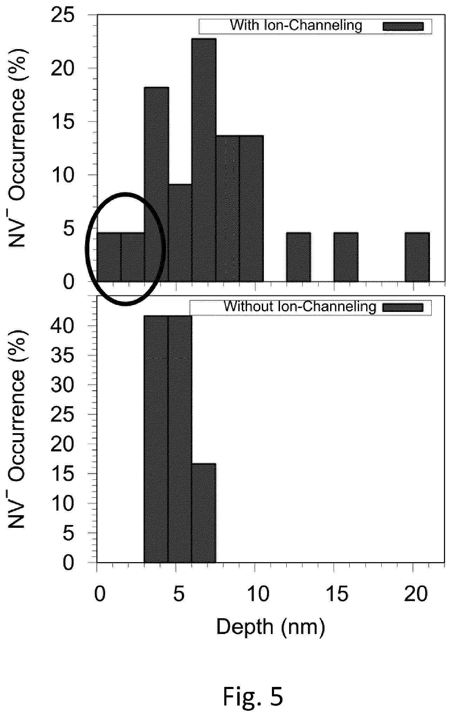

With the creation of the colour centres completed, the colour centres may be further characterized via confocal microscopy and spin manipulation in step S6. The results of an example of this analysis can be seen in Figs. 5 to 7.

Fig. 3 shows a cross section of a process chamber used for ICP etching. The chamber is double walled, with an outer wall 31 and a grounded inner wall 32. The substrate holder 33 is grounded as well. A gas inlet 34 and gas outlet 35 in combination with mass flow controllers (not shown) are used to control the gas flow and pressure. At the top, inductive coils 36 are driven by a RF power source 37. The current circulating through the coils 36 generates a magnetic field around them and a corresponding azimuthal electric field in which electrons are accelerated, resulting in the discharge of plasma 38. The geometry of the chamber is designed for the plasma 38 to extend just enough towards the sample (diamond substrate 1) to gently etch its surface.

The identification of the miscut angle α between the surface 11 of the diamond substrate and the (100) plane of the crystal 12 via x-ray diffraction is illustrated in Fig. 4a. An x-ray source 41 is provided to irradiate the diamond substrate 1, with the Bragg reflected beam detected with the x-ray detector 42. For the measurement, the angle χ is varied (indicated by the second, dotted outline of the substrate 1) for each chosen angle ξ in order to maximise the intensity of the beam which is Bragg-reflected at the plane 12. As can be seen in the accompanying plot, the miscut angle α can then be derived from the amplitude of the resulting sinusoidal oscillation, in this example about 1.6°.

Fig. 4b illustrates the structure of the diamond substrate 1 viewed from above for three different miscut angles. This also illustrates how an ion beam incident along the x-axis "sees" the crystal structure. For α = 0°, only the top layer of carbon atoms is visible, with the remaining crystal structure aligned behind them. "Channels" through the structure are clearly visible. For α = 5°, additional lattice atoms are visible and the free gaps between them is reduced. For α = 10° the visible structure is nearly amorphous. While an incident particle such as the ion to be implanted may pass nearly unimpaired through the crystal lattice for α = 0°, it will undergo a number of collisions for α = 10°. This gives a simplified explanation of the channelling effect in the diamond lattice. Accordingly, when the miscut angle α is eliminated by tilting the substrate 1, the implanted ions may reach a deeper depth in the crystal.

Figs. 5 to 7 characterize results of the method of the present invention more closely a diamond at the example of substrate with nitrogen-vacancy centres. Fig. 5 shows a comparison between the depth distribution of nitrogen vacancies achieved according to the proposed method by utilizing ion channelling and ICP etching, and the depth distribution achieved by a conventional method of creating colour centres. As can be seen in the circled area, the method according to the invention creates NV centres at depths of under 5 nm and in particular below 3 nm. Up to 25 % of the detected NV centres are located at a depth of less than 3 nm. In comparison, the conventional method is unable to produce any colour centres at these depths.

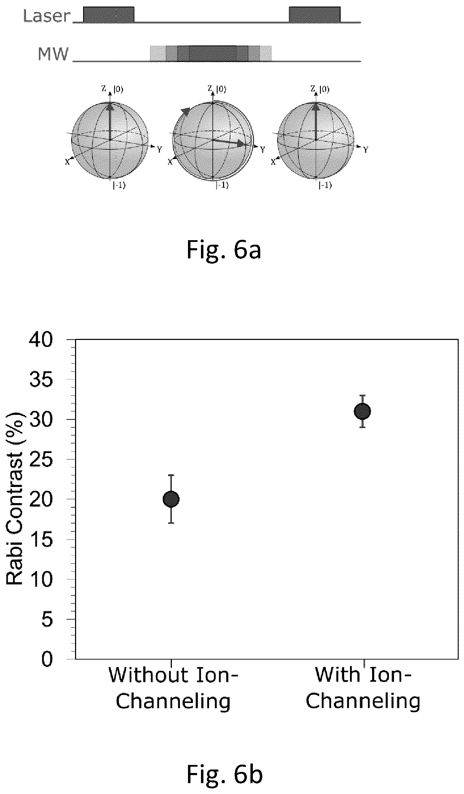

Fig. 6a illustrates the sequence used for Rabi oscillation measurements. The top part shows the two laser pulses for initialisation and readout of the measured spin state and the microwave pulse of variable duration τ to coherently manipulate the spin. Underneath, the corresponding spin states are represented on the Block sphere, with the initialized state, the coherent superposition state and the recovery of the population. Fig. 6b shows the Rabi contrast derived from multiple measurements with different durations of microwave pulses. This Rabi contrast can be considered a metric for the signal strength and stability of the produced colour centres. As can be seen, for the conventionally prepared NV centres, the Rabi contrast is about 20 %, while reaching over 30 % with the proposed method.

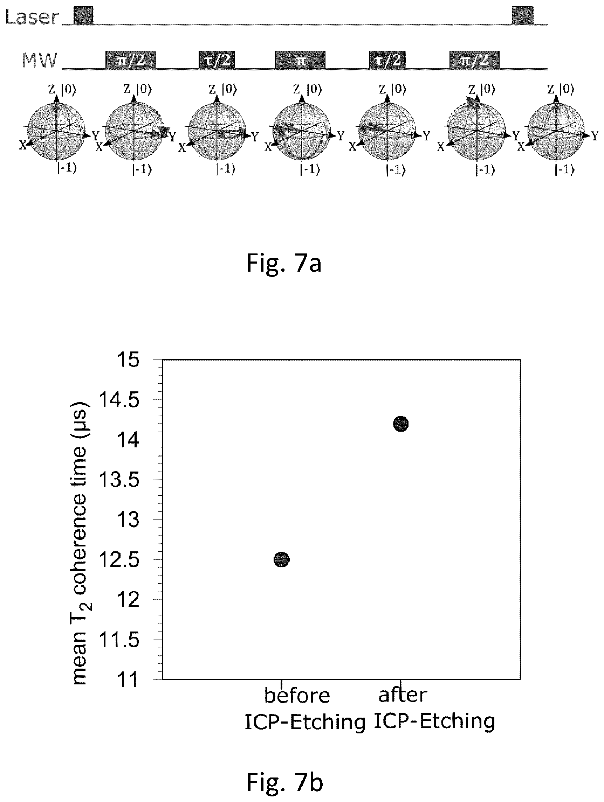

Fig. 7a illustrates the Hahn echo sequence used to measure the coherence time T₂. The top part shows the two laser pulses for initialisation and readout of the measured spin state. The spin state is first brought into superposition with a π/2 pulse, then allowed to acquire a phase during the waiting times τ/2 after which it is rotated 180° by the π pulse, such that the sign of the acquired phase is inverted during the second waiting time. Underneath, this evolution of the spin state is represented on the Block sphere. By performing this sequence with different waiting times τ and measuring the coherence signal, the coherence time T₂ can be derived by fitting the signal with a stretched exponential function. The coherence time T₂ is generally a function of the depth of the NV centre, with longer coherence times resulting from larger depths. However, as can be seen in Fig. 7b, the ICP etching step also improves the mean coherence time. This is due to the effect of the oxygen termination on surface bonds and the removal of crystal lattice damaged during the ion implantation within the upper layers of the diamond structure. These parasitic defects would otherwise lead to spin noise in the environment of the NV centres and thus reduce the coherence time T₂.

Therefore, the results shown in Figs. 5 to 7 show that NV centres produced by utilizing ion channelling and ICP etching are located close to the surface of the substrate while still providing improved signal strengths and coherence times.

As described, the method allows for the production of shallow colour centres with a large increase in quality without requiring much additional technical effort. In contrast to diamond substrates with shallow colour centres produced with conventional methods, the shallow colour centres are closer to the surface of the substrate and show improved properties regarding their signal strength and coherence time. Accordingly, the diamond substrates with shallow colour centres prepared with this methods are particularly attractive for applications in quantum sensing and computing.

The examples described here are not limiting. In particular, the features of these examples may be combined to achieve additional effects. It is obvious to the skilled person that changes can be made to these examples without departing from the fundamental principles of the subject-matter of this patent application, the scope of which is defined in the claims.

## Claims

1. Method for the creation of shallow colour centres (2) in a diamond substrate (1), comprising the steps of
identifying (S1) a miscut angle between a normal of a surface plane (11) of the diamond substrate (1) and a major crystal axis <100> of a diamond crystal structure,
implantation of ions (S2) using an ion beam under an angle, such that the miscut angle is eliminated and the ion beam enters the diamond structure parallel to the major crystal axis of the diamond structure,
annealing (S3) of the diamond substrate (1),
measuring (S4) a depth of implanted colour centres (2),
inductively coupled plasma etching (S5) of the diamond substrate (1) such that the implanted colour centres (2) comprise negatively charged colour centres (2) situated at a depth of less than 1 nm from the surface of the diamond substrate (1).

2. Method according to claim 1, wherein implanted ions are nitrogen-ions, resulting in nitrogen-vacancy colour centres.

3. Method according to claim 1, wherein implanted ions are silicon-ions, resulting in silicon-vacancy colour centres.

4. Method according to any of the claims 1 to 3, wherein the miscut angle is identified (S1) by x-ray diffraction analysis.

5. Method according to any of claims 1 to 4, wherein the implantation of ions (S2) is carried out at an ion energy of between 1 keV and 10 keV, in particular between 4.5 and 5.5 keV, and with a dose of between 1×10⁹ and 5×10¹² ions per cm².

6. Method according to any of claims 1 to 5, wherein annealing (S3) is performed at a temperature of between 800 °C and 1500 °C and a pressure between 1×10⁻⁸ mbar and 1×10⁻⁶ mbar.

7. Method according to claim 6, wherein after annealing (S3), the diamond substrate (1) is cleaned, preferably in a mixture of sulfuric acid, perchloric acid and nitric acid at a temperature of between 100 °C and 130 °C.

8. Method according to any of the claims 1 to 7, wherein the inductively coupled plasma etching (S5) is performed with an oxygen plasma.

9. Method according to any one of the claims 1 to 8, wherein the implantation of ions (S2) and the inductively coupled plasma etching (S5) are performed such that between 5 and 75 %, preferably between 10 and 50 %, further preferably between 15 and 35 %, especially preferred between 20 % and 25 % of the negatively charged colour centres (2) are situated at a depth of less than 5 nm from the diamond surface.

10. Method according to any one of the claims 1 to 9, wherein the implantation of ions (S2) and the inductively coupled plasma etching (S5) are performed such that the negatively charged colour centres (2) provide a Rabi contrast of more than 15%, preferably between 20 and 60 %, more preferably between 20 and 40 %, especially preferred between 25 and 35 %, when performing Rabi oscillation measurements on the electron spin of the colour centres (2).

11. Method according to any one of the claims 1 to 10, wherein the implantation of ions (S2) and the inductively coupled plasma etching (S5) are performed such that the colour centres (2) have a mean coherence time of between 5 µs and 40 µs at a depth of less than 5 nm when measured via a Hahn echo sequence.

12. Method according to any one of the claims 1 to 11, wherein the diamond substrate (1) is grown via chemical-vapour deposition.

## Patentansprüche

1. Verfahren zur Erzeugung oberflächennaher Farbzentren (2) in einem Diamantsubstrat (1), umfassend die Schritte:
Bestimmen (S1) eines Fehlorientierungs-Winkels zwischen einer Normalen einer Oberflächenebene (11) des Diamantsubstrats (1) und einer Hauptkristallachse <100> einer Diamantkristallstruktur,
Implantation von Ionen (S2) mittels eines Ionenstrahls unter einem Winkel, derart, dass der Fehlorientierungs-Winkel kompensiert wird und der Ionenstrahl in die Diamantstruktur parallel zur Hauptkristallachse der Diamantkristallstruktur eintritt,
Tempern (S3) des Diamantsubstrats (1),
Messen (S4) einer Tiefe implantierter Farbzentren (2),
induktiv gekoppeltes Plasmaätzen (S5) des Diamantsubstrats (1) derart, dass die implantierten Farbzentren (2) negativ geladene Farbzentren (2) umfassen, die in einer Tiefe von weniger als 1 nm von der Oberfläche des Diamantsubstrats (1) angeordnet sind.

2. Verfahren nach Anspruch 1, wobei die implantierten Ionen Stickstoffionen sind, wodurch Stickstoff-Leerstellen-Farbzentren entstehen.

3. Verfahren nach Anspruch 1, wobei die implantierten Ionen Siliziumionen sind, wodurch Silizium-Leerstellen-Farbzentren entstehen.

4. Verfahren nach einem der Ansprüche 1 bis 3, wobei der Fehlorientierungs-Winkel (S1) durch Röntgenbeugungsanalyse bestimmt wird.

5. Verfahren nach einem der Ansprüche 1 bis 4, wobei die Implantation der Ionen (S2) mit einer Ionenenergie zwischen 1 keV und 10 keV, insbesondere zwischen 4,5 und 5,5 keV, und mit einer Fluenz zwischen 1×10⁹ und 5×10¹² Ionen pro cm² durchgeführt wird.

6. Verfahren nach einem der Ansprüche 1 bis 5, wobei das Tempern (S3) bei einer Temperatur zwischen 800°C und 1500°C und einem Druck zwischen 1×10⁻⁸ mbar und 1×10⁻⁶ mbar durchgeführt wird.

7. Verfahren nach Anspruch 6, wobei das Diamantsubstrat (1) nach dem Tempern (S3) gereinigt wird, vorzugsweise in einer Mischung aus Schwefelsäure, Perchlorsäure und Salpetersäure bei einer Temperatur zwischen 100°C und 130°C.

8. Verfahren nach einem der Ansprüche 1 bis 7, wobei das induktiv gekoppelte Plasmaätzen (S5) mit einem Sauerstoffplasma durchgeführt wird.

9. Verfahren nach einem der Ansprüche 1 bis 8, wobei die Ionenimplantation (S2) und das induktiv gekoppelte Plasmaätzen (S5) so durchgeführt werden, dass zwischen 5 und 75 %, vorzugsweise zwischen 10 und 50 %, weiter vorzugsweise zwischen 15 und 35 %, besonders bevorzugt zwischen 20 % und 25 % der negativ geladenen Farbzentren (2) in einer Tiefe von weniger als 5 nm von der Diamantoberfläche angeordnet sind.

10. Verfahren nach einem der Ansprüche 1 bis 9, wobei die Ionenimplantation (S2) und das induktiv gekoppelte Plasmaätzen (S5) so durchgeführt werden, dass die negativ geladenen Farbzentren (2) bei Durchführung von Rabi-Oszillationsmessungen am Elektronenspin der Farbzentren (2) einen Rabi-Kontrast von mehr als 15 %, vorzugsweise zwischen 20 und 60 %, stärker bevorzugt zwischen 20 und 40 %, besonders bevorzugt zwischen 25 und 35 %, liefern.

11. Verfahren nach einem der Ansprüche 1 bis 10, wobei die Ionenimplantation (S2) und das induktiv gekoppelte Plasmaätzen (S5) so durchgeführt werden, dass die Farbzentren (2) in einer Tiefe von weniger als 5 nm eine mittlere Kohärenzzeit zwischen 5 µs und 40 µs bei der Messung mittels einer Hahn-Echo-Sequenz aufweisen.

12. Verfahren nach einem der Ansprüche 1 bis 11, wobei das Diamantsubstrat (1) mittels chemischer Gasphasenabscheidung hergestellt wird.

## Revendications

1. Procédé de création de centres de couleur peu profonds (2) dans un substrat en diamant (1), comprenant les étapes consistant à :
identification (S1) un angle de décalage entre une normale à un plan de surface (11) du substrat en diamant (1) et un axe cristallin principal <100> d'une structure cristalline de diamant,
implantation d'ions (S2) au moyen d'un faisceau ionique sous un angle tel que l'angle de décalage soit éliminé et que le faisceau ionique pénètre dans la structure de diamant parallèlement à l'axe cristallin principal de la structure cristalline de diamant,
recuit (S3) le substrat en diamant (1),
mesure (S4) une profondeur des centres de couleur implantés (2),
gravure par plasma à couplage inductif (S5) du substrat en diamant (1), de telle sorte que les centres de couleur implantés (2) comprennent des centres de couleur chargés négativement (2) situés à une profondeur inférieure à 1 nm de la surface du substrat en diamant (1).

2. Procédé selon la revendication 1, dans lequel les ions implantés sont des ions azote, ce qui donne lieu à des centres de couleur de type lacune d'azote.

3. Procédé selon la revendication 1, dans lequel les ions implantés sont des ions silicium, ce qui donne lieu à des centres de couleur de type lacune de silicium.

4. Procédé selon l'une quelconque des revendications 1 à 3, dans lequel l'angle de décalage est identifié (S1) par analyse de diffraction des rayons X.

5. Procédé selon l'une quelconque des revendications 1 à 4, dans lequel l'implantation d'ions (S2) est effectuée avec une énergie de faisceau ionique comprise entre 1 keV et 10 keV, en particulier entre 4,5 et 5,5 keV, et avec une fluence comprise entre 1×10⁹ et 5×10¹² ions par cm².

6. Procédé selon l'une quelconque des revendications 1 à 5, dans lequel le recuit (S3) est effectué à une température comprise entre 800°C et 1500°C et à une pression comprise entre 1×10⁻⁸ mbar et 1×10⁻⁶ mbar.

7. Procédé selon la revendication 6, dans lequel, après le recuit (S3), le substrat de diamant (1) est nettoyé, de préférence dans un mélange d'acide sulfurique, d'acide perchlorique et d'acide nitrique à une température comprise entre 100°C et 130°C.

8. Procédé selon l'une quelconque des revendications 1 à 7, dans lequel la gravure par plasma à couplage inductif (S5) est effectuée au moyen d'un plasma d'oxygène.

9. Procédé selon l'une quelconque des revendications 1 à 8, dans lequel l'implantation d'ions (S2) et la gravure par plasma à couplage inductif (S5) sont effectuées de telle sorte qu'entre 5 et 75 %, de préférence entre 10 et 50 %, plus préférablement entre 15 et 35 %, et de manière particulièrement préférée entre 20 % et 25 % des centres de couleur chargés négativement (2) se situent à une profondeur inférieure à 5 nm de la surface du diamant.

10. Procédé selon l'une quelconque des revendications 1 à 9, dans lequel l'implantation d'ions (S2) et la gravure par plasma à couplage inductif (S5) sont effectuées de telle sorte que les centres de couleur chargés négativement (2) fournissent un contraste de Rabi supérieur à 15 %, de préférence compris entre 20 et 60 %, plus préférablement entre 20 et 40 %, et de manière particulièrement préférée entre 25 et 35 %, lors de la réalisation de mesures d'oscillations de Rabi sur le spin électronique des centres de couleur (2).

11. Procédé selon l'une quelconque des revendications 1 à 10, dans lequel l'implantation d'ions (S2) et la gravure par plasma à couplage inductif (S5) sont effectuées de telle sorte que les centres de couleur (2) présentent un temps de cohérence moyen compris entre 5 µs et 40 µs à une profondeur inférieure à 5 nm, lorsqu'il est mesuré au moyen d'une séquence d'écho de Hahn.

12. Procédé selon l'une quelconque des revendications 1 à 11, dans lequel le substrat de diamant (1) est élaboré par dépôt chimique en phase vapeur.
